# EUROPEAN PATENT SPECIFICATION

(11) **EP 2 166 623 B1**
(45) Date of publication and mention of the grant of the patent: **05.09.2018**
(21) Application number: 09011795.3
(22) Date of filing: 16.09.2009
(51) Int. Cl.: H01R 13/03, H01R 13/24

(54) **Surface mount contact**
Oberflächenmontierter Kontakt
Element de contact pour montage en surface

(30) Priority: 16.09.2008 JP 2008236579
(43) Date of publication of application: 24.03.2010
(73) Proprietor: Kitagawa Industries Co., Ltd., Inazawa-shi, Aichi 4928446 (JP)
(72) Inventor: Yumi, Hideo, Nagoya-shi, Aichi-ken 460-0012 (JP)
(74) Representative: Patentanwälte Magenbauer & Kollegen Partnerschaft mbB

(56) References cited:
- EP-A2- 0 860 792
- JP-A- 10 040 990
- JP-A- 2000 255 252
- JP-A- 2002 170 615
- US-A- 4 921 430
- US-A1- 2001 034 162
- US-B1- 6 478 586

## Description

### BACKGROUND

The present invention relates to a surface mount contact and particularly relates to a surface mount contact that interposes between a mounted conductor and a pressing conductive member. The surface mount contact makes the mounted conductor conductive to the pressing conductive member when the pressing conductive member and the mounted conductor are proximate to each other.

Unexamined Japanese Patent Application Publication No. 2002-170615 discloses a surface mount contact according to the preamble of claim 1. The surface mount contact includes a base portion having a solder surface provided for soldering the surface mount contact and a movable portion having a contact region for contact conduction. This conventional surface mount contact is mounted on a mounted conductor so as to establish a conduction between the mounted conductor and a pressing conductive member that pressure-contacts with the contact region. The movable portion is elastically displaced in a direction of being proximate to the base portion when the contact region is pressed toward the base portion.

The surface mount contact is made of a conductive metal plate formed into a generally U shape. The surface mount contact includes the movable portion having a longitudinal one end elastically bendable. The movable portion also has the other end portion formed by a pair of elastic pieces narrower than other portions. In case of this conventional surface mount contact, by pressure-contacting the pressing conductive member with the contact region of the movable portion, the movable portion is bent elastically downward and an electrical contact state between the pressing conductive member and the movable portion is kept. At that time, if the end portion of the movable portion abuts on the base portion of the surface mount contact, the elastic pieces forming the end portion are bent, thereby inhibiting a contact pressure between the pressing conductive member and the movable portion from excessively increasing.

However, the conventional surface mount contact as stated above has the following problems. If the elastic pieces of the movable portion abut on the base portion of the surface mount contact, conductive paths via the respective elastic pieces are formed. As a result, an electric resistance, i.e., an impedance, of the surface mount contact slightly changes as a whole. If such a change occurs to the impedance, it is disadvantageously necessary to make adjustments in accordance with the impedance change when the surface mount contact is used to connect, for example, a printed circuit board for RFID (Radio Frequency Identification) with an antenna.

### SUMMARY

In a first aspect of the present invention, it is preferable that a surface mount contact is configured to prevent an impedance change by the formation of a new conductive path.

In the first aspect of the invention, a surface mount contact that interposes between a mounted conductor and a pressing conductive member to make the mounted conductor conductive to the pressing conductive member when the mounted conductor and the pressing conductive member are proximate to each other, the surface mount contact comprising: a base portion solderable to the mounted conductor; a movable portion elastically deformable according to a distance between the mounted conductor and the pressing conductive member, at least a part of the movable portion being closer to the base portion when the movable portion elastically deforms; and an insulating coating film provided in a region where the movable portion is closer to the base portion and inhibiting electric contact between the movable portion and the base portion, wherein the movable portion has a vacuum-attraction surface that is in parallel to the solder surface in a state in which no external force acts on the surface mount contact, and the insulating coating film is also provided on the vacuum-attraction surface, and wherein a reflectivity of a portion in which the insulating coating film is provided differs from of a portion in which no insulating coating film is provided.

The surface mount contact according to the first aspect of the invention includes the insulating coating film that is provided either entirely or partially in the region where the movable portion is proximate to the base portion when the movable portion is elastically displaced in a direction closer to the base portion. Due to this, in the region where the insulating coating film is provided, a new conductive path cannot be formed even if the movable portion contacts with any portion when being elastically displaced in the direction in which the movable portion contacts with the base portion. Therefore, occurrence of the following problem can be avoided: an electrical resistance, i.e., an impedance, of the movable portion, slightly changes as a whole due to formation of such a conductive path. Furthermore, occurrence of a failure resulting from the impedance change can be avoided.

In what range in a region where the movable portion is closer to the base portion when the movable portion is elastically displaced in a direction closer to the base portion the insulating coating film is provided, that is, whether the insulating coating film is provided entirely or partially and on which part the insulating coating film is provided if the insulating coating film is provided partially are not decided uniquely by a structure, a shape and the like of the surface mount contact. However, these respects may be decided according to the structure, the shape and the like of the surface mount contact based on whether or not these respects are necessary and sufficient for preventing formation of the "new conductive path".

As the insulating coating film, available is an insulating coating film obtained by applying a plastic film using an adhesive material, a coating film provided by cold setting coating, a coating film provided by bake hardening coating or the like. Particularly if the insulating coating film provided by bake hardening coating is used for the surface mount contact, a thickness and a color of the coating film can be easily adjusted as compared with use of the plastic film. Moreover, a polymerization reaction occurs to the coating film by heating the coating film during baking. It is, therefore, possible to form a dense and strong coating film.

Furthermore, if the surface mount contact is formed by pressing a sheet metal, it is particularly suitable to use the bake hardening coating so as not to cause separation of the coating film.

If the insulating film is provided by bake hardening coating, the coating film is stable against heat since the coating film is already heated once. Due to this, it may be possible to avoid a problem resulting from heating even if the surface mount contact passes through a reflow furnace when attaching the contact to a printed circuit board.

Moreover, in the surface mount contact, it is preferable that the base portion includes a base plate having the solder surface provided on a lower surface, one end of the movable portion is connected to the base plate via a folded spring portion and the other end of the movable portion is a free end, and that the insulating coating film is provided on each of or one of a surface of the other end that is the free end of the movable portion which surface faces the base plate and a portion of the base plate which portion is predicted to contact with the free end of the movable portion.

By so configuring, a region where the insulating coating film is provided can be made relatively small.

Furthermore, in the surface mount contact as stated above, a magnetic material may be dispersed either entirely or partially in the insulating coating film.

By so configuring, the insulating coating film in which the magnetic material is dispersed functions as a noise filter since such film absorbs noise signal.

Furthermore, in the surface mount contact, the movable portion has a vacuum-attraction surface that is in parallel to the solder surface in a state in which no external force acts on the surface mount contact, and that the insulating coating film is also provided on the vacuum-attraction surface.

By so configuring, the insulating coating film provided on the vacuum-attraction surface makes an optical property (for example, reflectivity) of the vacuum-attraction surface differ from that of an adjacent portion (in which no insulating coating film is provided). It is, therefore, possible to improve detection accuracy when an optical detector detects a position of the vacuum-attraction surface.

It is to be noted that "the vacuum-attraction surface that is in parallel to the solder surface" does not mean being a precisely parallel in a strict sense but means that soldered surface and the vacuum-attraction surface are designed to be parallel. In an actual product, the vacuum-attraction surface is "almost parallel to" the solder surface.

It is further preferable that the insulating coating film is provided by bake hardening coating. In that case, a thickness and a color of the coating film can be easily adjusted as stated above. Moreover, a polymerization reaction occurs to the coating film by heating the coating film during baking. It is, therefore, possible to form a dense and strong coating film.

### BRIEF DESCRIPTION OF THE DRAWINGS

An embodiment of the present invention will now be described by way of example with reference to the accompanying drawings, in which:
FIG. 1A is a plan view of a surface mount contact according to a first embodiment of the present invention; FIG. 1B is a front view of the surface mount contact according to the first embodiment; FIG. 1C is a bottom view of the surface mount contact according to the first embodiment; FIG. 1D is a left side view of the surface mount contact according to the first embodiment; FIG. 1E is a perspective view of the surface mount contact according to the first embodiment;
FIGS. 2A, 2B and 2C are explanatory views for use of the surface mount contact according to the first embodiment;
FIGS. 3A and 3B are explanatory views of an example of arranging an insulating coating film of the surface mount contact according to the first embodiment;
FIG. 4A is a front view of a surface mount contact according to a second embodiment of the present invention; FIG. 4B is a side view of the surface mount contact according to the second embodiment; FIG. 4C is a perspective view of the surface mount contact according to the second embodiment; and
FIG. 5 is an explanatory view for use of the surface mount contact according to the second embodiment.

### DETAILED DESCRIPTION OF THE PREFERRED EMBODIMENTS

### [FIRST EMBODIMENT]

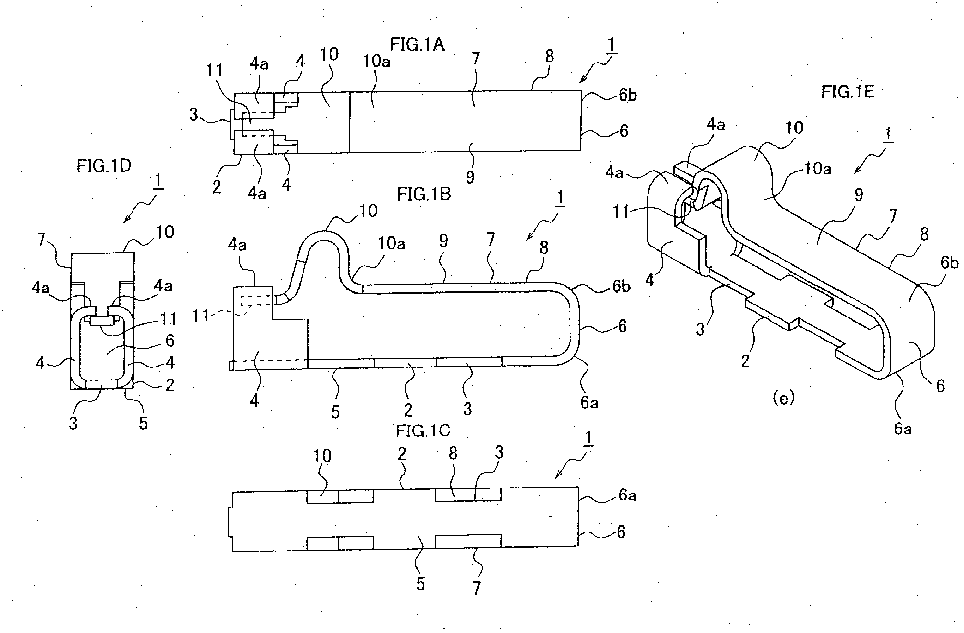

As shown in FIGS. 1A to 1E, a surface mount contact 1 according to a first embodiment of the present invention is formed by pressing a sheet metal having a spring property (such as beryllium copper, phosphor bronze or stainless steel). The surface mount contact 1 has a generally U shape as a whole. The surface mount contact 1 includes a base portion 2, a spring portion 6, and a movable portion 7.

The base portion 2 includes a planar base plate 3 and a pair of guides 4.

A lower surface of the base plate 3 is almost flat and functions as a solder surface 5 used for soldering the surface mount contact 1.

Each of the paired guides 4 is raised from a side surface of an end of the base plate 3 to be perpendicular to the base plate 3, and an upper end of each guide 4 is bent almost at 90 degrees toward the counterpart guide 4 and the bent upper end of the guide 4 serves as a restriction piece 4a.

The spring portion 6 is connected to an opposite end of the base plate 3 to the end on the guides 4-side to be almost perpendicular to the base plate 3, and an upper end of the spring portion 6 is connected to the movable portion 7. The spring portion 6 functions as a spring while including up to a connecting portion 6a connected to the base plate 3 and a connecting portion 6b connected to the movable portion 7, each of which connecting portions 6a and 6b is bent into a quarter circular arc (round) shape.

The movable portion 7 includes a planar movable plate 8 adjacent to the spring portion 6 (connecting portion 6b) and a contact portion 10. An upper surface of the movable plate 8 functions as a vacuum-attraction surface 9. In a state in which no external force acts on the surface mount contact 1, the movable plate 8 and the base plate 3 are parallel to each other (and designed to be parallel) and the vacuum-attraction surface 9 and the solder surface 5 are also parallel to each other.

The contact portion 10 is connected to an opposite end of the movable plate 8 to the spring portion 6-side end. The contact portion 10 is connected to the movable plate 8 at a foot 10a that is of a semicylindrical shape convex upward and that is bent into a quarter circular arc (round) shape. A top of the contact portion 10, in particular, serve as a contact region.

A restriction tongue 11 is connected to the contact portion 10 on an opposite side to the foot 10a. The restriction tongue 11 enters below the restriction pieces 4a and is stopped by lower surfaces of the restriction pieces 4a, thereby inhibiting the movable portion 7 from being displaced in a direction away from the base plate 3.

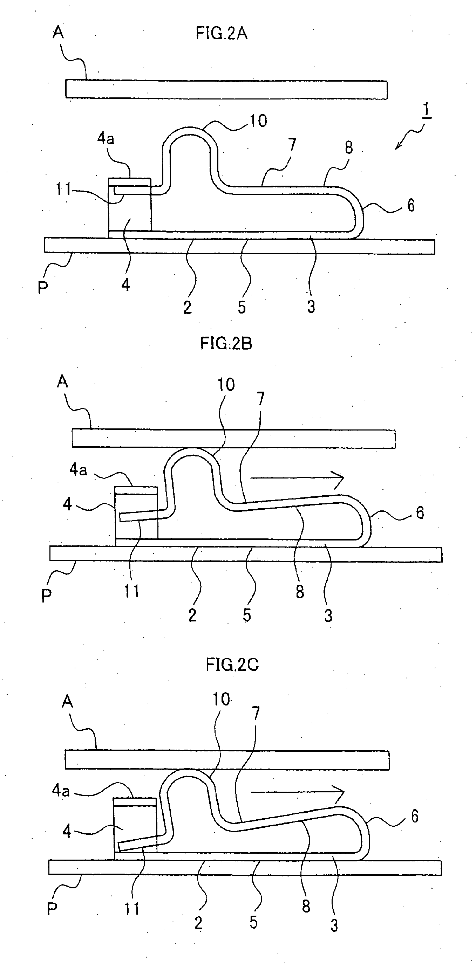

As shown in FIGS. 2A to 2C, the surface mount contact 1 according to this embodiment is surface-mounted on a printed circuit board P (corresponding to a mounted conductor) by soldering the solder surface 5 of the base plate 3 onto a pattern of the printed circuit board P. The printed circuit board P and a pressing conductive member (such as an antenna A) arranged to face the printed circuit board P press the surface mount contact 1 so as to sandwich the surface mount contact 1 between the printed circuit board P and the antenna A (FIG. 2B). As a result, a lower surface of the antenna A presses the top of the contact portion 10 (contact region). Therefore, the movable portion 7 is elastically displaced in a direction close to the base plate 3 while using the spring portion 6 as a fulcrum.

Action of the spring portion 6 to follow the elastic displacement generates an elastic bounce. Due to this, the lower surface of the antenna A pressure-contacts with and is electrically conductive to the top of the contact portion 10 (contact region). Accordingly, the antenna A and the pattern of the printed circuit board P are conductive to each other via the surface mount contact 1.

If a downward displacement of the movable portion 7 is large after the antenna A presses the contact region, the restriction tongue 11 possibly contacts with an upper surface of the base plate 3 as shown in FIG. 2C.

According to the conventional technique, if the restriction tongue 11 contacts with the base plate 3, a new conductive path passing from the contact portion 10 through the restriction tongue 11 to the base plate 3 is formed as well as an existing conductive path passing from the contact portion 10 through the movable plate 8 and the spring portion 6 to the base plate 3.

However, an insulating coating film is provided on the surface mount contact 1 according to this embodiment so as to prevent formation of such a new conductive path. An example of providing the insulating coating film will next be described.

### [FIRST EXAMPLE OF PROVIDING INSULATING COATING FILM]

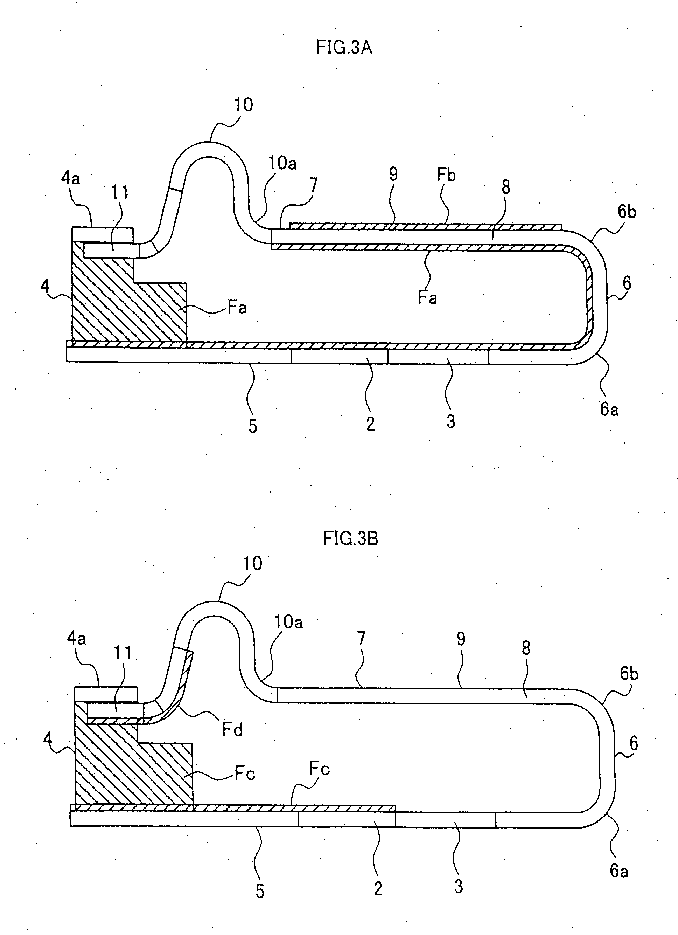

In an example shown in FIG. 3A, a sequence of an insulating coating film Fa is provided on an inner surface (a surface opposite to the solder surface 5) of the base plate 3, an inner surface of the spring portion 6 (including the connecting portions 6a and 6b) continuous to the inner surface of the base plate 3, an inner surface (a surface opposite to the vacuum-attraction surface 9) of the movable plate 8 continuous to the inner surface of the spring portion 6 and inner surfaces of the guides 4. Furthermore, an insulating coating film Fb is provided on the upper surface (vacuum-attraction surface 9) of the movable plate 8.

These insulating coating films Fa and Fb are formed out of epoxy resin, polyimide resin, PES (Poly Ether Sulphone), fluororesin or the like and obtained by subjecting such a material to bake hardening coating through a baking treatment at 200°C to 300°C for 30 to 100 seconds. Baking temperature and baking time differ according to the type, thickness and the like of the resin. As the insulating coating film Fb, a coating material obtained by dispersing a magnetic material (ferrite or metal magnetic material) in the above-stated resin is used:

In the example shown in FIG. 3A, the insulating coating film Fa is provided in the above-stated range. Due to this, in a region where the insulating coating film Fa is provided, even if the movable portion 7 contacts with the other portions when being elastically displaced in a direction closer to the base portion 2, a new conductive path is not formed. Therefore, occurrence of the following problem can be avoided: the electric resistance, that is, impedance, slightly changes as a whole by formation of such a conductive path. In addition, occurrence of a failure resulting from the impedance change can be avoided.

Since the insulating coating film Fb is formed by dispersing the magnetic material in the resin, the insulating coating film Fb functions as a noise filter since such film absorbs noise signal. Besides, the insulating coating film Fb provided on the vacuum-attraction surface 9 makes an optical property (reflectivity) of the vacuum-attraction surface 9 differ from that of an adjacent portion (the foot 10a and a part of the movable plate 8 continuous to the foot 10a) in which no insulating coating film is provided. It is, therefore, possible to improve detection accuracy during detection of a position of the vacuum-attraction surface 9 by an optical detector (not shown).

In other words, if a suction nozzle of an automatic mounting device (not shown) vacuum-attracts the vacuum-attraction surface 9, the optical detector detects the position of the vacuum-attraction surface 9. Since the detection accuracy during the detection is improved, position accuracy with which the suction nozzle vacuum-attracts the vacuum-attraction surface is also improved.

### [SECOND EXAMPLE OF PROVIDING INSULATING COATING FILM]

In an example shown in FIG. 3B, a sequence of an insulating coating film Fc is provided on an inner surface of a tip end side (a portion to which the guides 4 are connected) of the base plate 3 and inner surfaces of the guides 4. A sequence of an insulating coating film Fd is provided on an inner surface of a tip end side portion of the contact portion 10 and an inner surface of the restriction tongue 11 (a surface facing the base plate 3). That is, the insulating coating film Fd is provided on the surface of a free end (a portion including the tip end side portion of the contact portion 10 and the restriction tongue 11) of the movable portion 7 which surface faces the base plate 3. In addition, the insulating coating film Fc is provided on the portion of the base plate 3 which portion is considered to contact with the free end of the movable portion 3. It is to be noted that the insulating coating films Fc and Fd are formed out of the same material as that of the insulating coating film Fa and obtained by subjecting such a material to bake hardening coating similarly to the insulating coating film Fa.

In the example shown in FIG. 3B, the insulating coating films Fc and Fd are provided in the above-stated ranges. Due to this, in regions where the insulating coating films Fc and Fd are provided, even if the movable portion 7 contacts with the other portions when being elastically displaced in a direction closer to the base portion 2, a new conductive path is not formed. Therefore, occurrence of the following problem can be avoided: the electric resistance, that is, impedance, slightly changes as a whole by formation of such a conductive path. In addition, occurrence of a failure resulting from the impedance change can be avoided.

Moreover, as evident from comparison with FIG. 3A, the regions where the insulating coating films Fc and Fd are provided can be made relatively small.

### [SECOND EMBODIMENT]

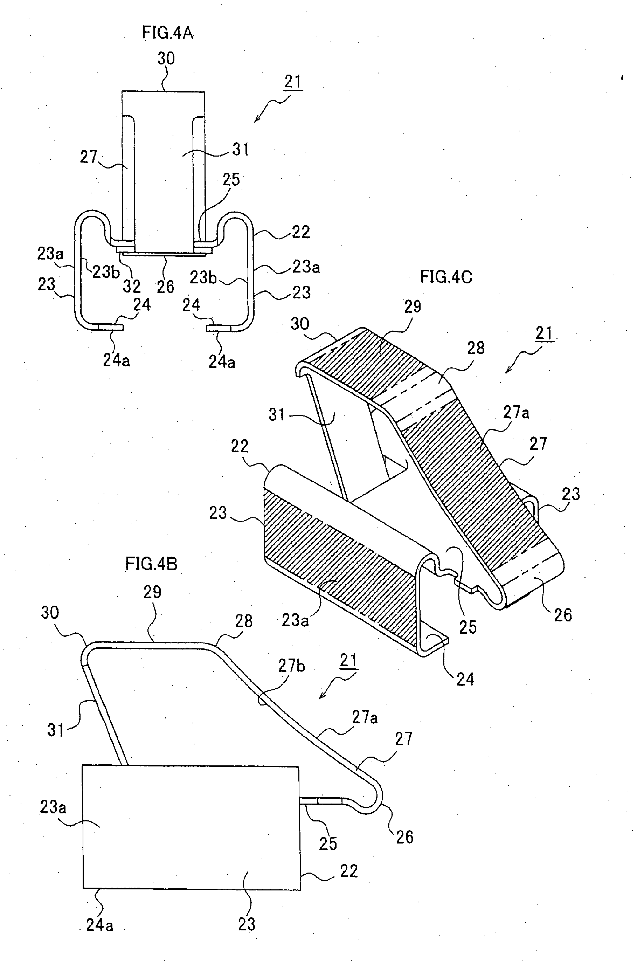

A surface mount contact 21 according to a second embodiment of the present invention is formed by pressing a sheet metal having a spring property (such as beryllium copper, phosphor bronze or stainless steel). The surface mount contact 21 has a structure shown in FIGS. 4A to 4C.

The surface mount contact 21 includes a base portion 22, a spring portion 26, and a movable portion 27.

The base portion 22 includes a pair of legs 23 and a support plate 25 connected between these legs 23. One end of each of the U-shaped legs 23 is connected to the support plate 25. The other end of each of the U-shaped legs 23 is suspended downward and a lower end of each of the legs 23 is bent at 90 degrees to serve as a base plate 24. A lower surface of the base plate 24 is almost flat and serves as a solder surface 24a for soldering the surface mount contact 21.

The support plate 25 is generally rectangular and the above-stated legs 23 (one end of the U-shaped portions) are connected to two opposing sides of the support plate 25, respectively. One end of the spring portion 26 is connected to a side of the support plate 25 other than the two sides to which the legs 23 are connected, respectively. As preferably shown in FIG. 4B, the spring portion 26 is a U-turn folded portion. The movable portion 27 is connected to the other end of the spring portion 26.

An elevating displacement plate 29 is connected to an upper end of the movable portion 27 via an obtuse corner portion 28. The corner portion 28 and/or the elevating displacement plate 29 serves as a contact region.

A steep sloping portion 31 is connected to an end of the elevating displacement plate 29 via an acute bent portion 30. A lower end of the steep sloping portion 31 is bent, and the bent lower end is a bent end 32. The bent end 32 has the same function as the restriction tongue 11 in the first embodiment. The bent end 32 enters below the support plate 25 and contacts with a lower surface of the support plate 25.

Because of the above-stated configuration, the elevating displacement plate 29 can be easily displaced downward toward the support plate 25. However, a displacement (folded deformation) of the elevating displacement plate 29 in a direction of widening a distance between the elevating displacement plate 29 and the support plate 25 is inhibited since the bent end 32 is stopped by the lower surface of the support plate 25.

In the surface mount contact 21 according to this embodiment, an insulating coating film F similar to the insulating coating film Fb described in the first embodiment is provided on an upper surface of the elevating displacement plate 29, an upper surface 27a and a lower surface 27b of the movable portion 27, outer surfaces 23a and inner surfaces 23b of the legs 23 and a lower surface of the bent end 32 by bake hardening coating.

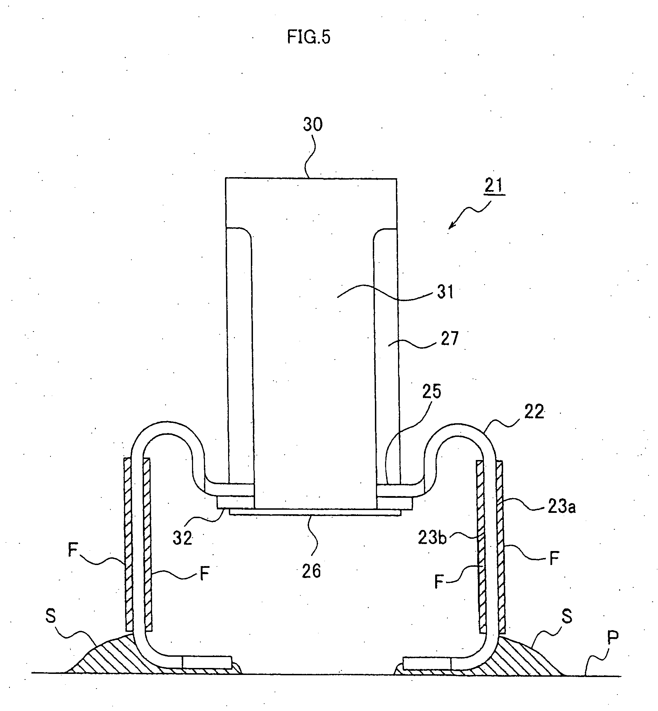

As shown in FIG. 5, this surface mount contact 21 is surface-mounted on a printed circuit board P by soldering the base plate 24 (solder surface 24a) onto a pattern of the printed circuit board P by a solder S. Similarly to the first embodiment, the printed circuit board P and a pressing conductive member (such as an antenna) arranged to face the printed circuit board P press the surface mount contact 21 so as to sandwich the surface mount contact 21 between the printed circuit board P and the antenna and the pressing conductive member is contacted with the corner portion 28 (contact region). The pressing conductive member is thereby made conductive to the pattern of the printed circuit board P (corresponding to a mounted conductor) via the surface mount contact 21.

Even if the lower surface of the bent end 32 contacts with the base plate 24 due to a deformation, then the bent end 32 is not made conductive to the base plate 24 and impedance change can be inhibited since the insulating coating film F is provided on the lower surface of the bent end 32 by bake hardening coating.

When the surface mount contact 21 is surface-mounted on the printed circuit board P, a suction nozzle of an automatic implementation device (not shown) vacuum-attracts an upper surface (a vacuum-attraction surface) of the elevating displacement plate 29. A position of the vacuum-attraction surface at the time of vacuum-attraction is detected by an optical detector (not shown). The insulating coating film F provided on the vacuum-attraction surface makes an optical property (reflectivity) of the vacuum-attraction surface differ from that of an adjacent portion (the corner portion 28 and a bent portion 30) in which no insulating coating film is provided. It is, therefore, possible to improve detection accuracy during detection of the position of the vacuum-attraction surface by the optical detector. Accordingly, position accuracy with which the suction nozzle vacuum-attracts the vacuum-attraction surface is also improved.

Moreover, as shown in FIG. 5, the insulating coating film F provided on the legs 23 inhibits the solder S from rising along surfaces of the legs 23. That is, the insulating coating film F can inhibit excessive solder rising.

Furthermore, since a magnetic material is dispersed in the insulating coating film F, the insulating coating film F functions as a noise filter since such film absorbs noise signal.

## Claims

1. A surface mount contact (1, 21) that interposes between a mounted conductor and a pressing conductive member to make the mounted conductor conductive to the pressing conductive member when the mounted conductor and the pressing conductive member are proximate to each other, the surface mount contact comprising: a base portion (2, 22) solderable to the mounted conductor; a movable portion (7, 27) elastically deformable according to a distance between the mounted conductor and the pressing conductive member, at least a part of the movable portion (7, 27) being closer to the base portion (2, 22) when the movable portion (7. 27) elastically deforms;
**characterised in that**
an insulating coating film (F, Fa, Fb, Fc, Fd) provided in a region where the movable portion (7, 27) is closer to the base portion (2, 22) and inhibiting electric contact between the movable portion (7, 27) and the base portion (2, 22), wherein the movable portion (7, 27) has a vacuum-attraction surface (9) that is in parallel to the solder surface (5, 24) in a state in which no external force acts on the surface mount contact (1, 21), and the insulating coating film (F, Fa, Fb, Fc, Fd) is also provided on the vacuum-attraction surface (9), and wherein a reflectivity of a portion in which the insulating coating film is provided differs from of a portion in which no insulating coating film is provided.

2. The surface mount contact (1, 21) according to claim 1, wherein the base portion (2, 22) includes a base plate (3, 24) having a solder surface (5, 24a) provided on a lower surface, one end of the movable portion (7, 27) is connected to the base plate (3, 24) via a folded spring portion (6, 26) and other end of the movable portion (7, 27) is a free end, and the insulating coating film (F, Fa, Fb, Fc, Fd) is provided at least one of a surface of the other end and a portion of the base plate (3, 24), the surface of the other end is the free end of the movable portion (7, 27) which surface faces the base plate (3, 24), and the portion of the base plate (3, 24) is predicted to contact with the free end of the movable portion (7, 27).

3. The surface mount contact (1, 21) according to claim 1 or claim 2, wherein a magnetic material is dispersed at least partially in the insulating coating film (F, Fa, Fb, Fc, Fd).

4. The surface mount contact (1, 21) according to one of claim 1 to claim 3, wherein the insulating coating film (F, Fa, Fb, Fc, Fd) is provided by bake hardening coating.

## Patentansprüche

1. Oberflächenmontierbarer Kontakt (1, 21), der zwischen einem montierten Leiter und einem leitenden Presselement angeordnet ist, um den montierten Leiter mit dem leitenden Presselement leitend zu verbinden, wenn der montierte Leiter und das leitende Presselement nahe beieinander liegen, wobei der Montagekontakt umfasst: einen Basisabschnitt (2, 22), der mit dem montierten Leiter verlötbar ist; einen beweglichen Abschnitt (7, 27), der entsprechend einem Abstand zwischen dem montierten Leiter und dem leitenden Presselement elastisch verformbar ist, wobei zumindest ein Teil des beweglichen Abschnitts (7, 27) näher an dem Basisabschnitt (2, 22) liegt, wenn der bewegliche Teil (7, 27) sich elastisch verformt; **dadurch gekennzeichnet, dass** ein isolierender Beschichtungsfilm (F, Fa, Fb, Fc, Fd), in einem Bereich vorgesehen ist, in dem der bewegliche Teil (7, 27) näher am Basisteil (2, 22) liegt und der einen elektrischen Kontakt zwischen dem beweglichen Teil (7 , 27) und dem Basisabschnitt (2, 22) verhindert, wobei der bewegliche Abschnitt (7, 27) eine Vakuumansaugoberfläche (9) aufweist, die in einem Zustand, in dem keine äußere Kraft auf den Oberflächenbefestigungskontakt (1, 21) parallel zur Lötoberfläche (5, 24) ist, wobei der isolierende Beschichtungsfilm (F, Fa, Fb, Fc, Fd) auch auf der Vakuumansaugoberfläche (9) bereitgestellt wird und wobei eine Reflexivität eines Abschnitts, in dem der isolierende Beschichtungsfilm bereitgestellt ist, sich von einem Abschnitt, in dem kein isolierender Beschichtungsfilm vorgesehen ist, unterscheidet.

2. Oberflächenmontierbarer Kontakt (1, 21) nach Anspruch 1, wobei der Basisabschnitt (2, 22) eine Basisplatte (3, 24) mit einer Lötoberfläche (5, 24a) aufweist, die an einer unteren Oberfläche vorgesehen ist, ein Ende des beweglichen Teils (7, 27) mit der Grundplatte (3, 24) über einen gebogenen Federteil (6, 26) verbunden ist und das andere Ende des beweglichen Teils (7, 27) ein freies Ende ist und der isolierende Überzugsfilm (F, Fa, Fb, Fc, Fd) an wenigstens einer Oberfläche des anderen Endes und/oder eines Teils der Grundplatte (3, 24) vorgesehen ist, wobei die Oberfläche des anderen Endes das freie Ende des beweglichen Abschnitts (7, 27) ist, dessen Oberfläche der Grundplatte (3, 24) zugewandt ist, und der Abschnitt der Grundplatte (3, 24) dazu ausgebildet ist, mit dem freien Ende des beweglichen Abschnitts (7, 27) in Kontakt zu stehen.

3. Oberflächenmontierbarer Kontakt (1, 21) nach Anspruch 1 oder Anspruch 2, wobei ein magnetisches Material zumindest teilweise in dem isolierenden Beschichtungsfilm (F, Fa, Fb, Fc, Fd) dispergiert ist.

4. Oberflächenmontierbarer Kontakt (1, 21) nach einem der Ansprüche 1 bis 3, wobei der isolierende Beschichtungsfilm (F, Fa, Fb, Fc, Fd) als Backhärtungs-Beschichtung ausgebildet ist.

## Revendications

1. Contact de montage en surface (1, 21) qui s'interpose entre un conducteur monté et un élément conducteur de pression pour rendre le conducteur monté conducteur par rapport à l'élément conducteur de pression lorsque le conducteur monté et l'élément conducteur de pression sont à proximité l'un de l'autre, le contact de montage en surface comprenant : une partie de base (2, 22) pouvant être soudée sur le conducteur monté ; une partie mobile (7, 27) pouvant être élastiquement déformée en fonction d'une distance entre le conducteur monté et l'élément conducteur de pression, au moins une portion de la partie mobile (7, 27) étant plus proche de la partie de base (2, 22) lorsque la partie mobile (7, 27) se déforme élastiquement ;
**caractérisé en ce que**
un film de revêtement isolant (F, Fa, Fb, Fc, Fd) prévu dans une région où la partie mobile (7, 27) est plus proche de la partie de base (2, 22) et empêchant un contact électrique entre la partie mobile (7, 27) et la partie de base (2, 22), où la partie mobile (7, 27) a une surface d'attraction par dépression (9) qui est parallèle à la surface de soudure (5, 24) dans un état où aucune force externe n'agit sur le contact de montage en surface (1, 21), et le film de revêtement isolant (F, Fa, Fb, Fc, Fd) est également prévu sur la surface d'attraction par dépression (9), et où une réflectivité d'une partie dans laquelle le film de revêtement isolant est prévu diffère d'une partie dans laquelle aucun film de revêtement isolant n'est prévu.

2. Contact de montage en surface (1, 21) selon la revendication 1, dans lequel la partie de base (2, 22) comporte une plaque de base (3, 24) ayant une surface de soudure (5, 24a) prévue sur une surface inférieure, une extrémité de la partie mobile (7, 27) est reliée à la plaque de base (3, 24) par l'intermédiaire d'une partie de ressort pliée (6, 26) et une autre extrémité de la partie mobile (7, 27) est une extrémité libre, et le film de revêtement isolant (F, Fa, Fb, Fc, Fd) est prévu sur au moins l'une d'une surface de l'autre extrémité et d'une partie de la plaque de base (3, 24), la surface de l'autre extrémité est l'extrémité libre de la partie mobile (7, 27) dont la surface fait face à la plaque de base (3, 24), et on prédit que la partie de la plaque de base (3, 24) entrera en contact avec l'extrémité libre de la partie mobile (7, 27).

3. Contact de montage en surface (1, 21) selon la revendication 1 ou 2, dans lequel un matériau magnétique est dispersé au moins partiellement dans le film de revêtement isolant (F, Fa, Fb, Fc, Fd).

4. Contact de montage en surface (1, 21) selon l'une des revendications 1 à 3, dans lequel le film de revêtement isolant (F, Fa, Fb, Fc, Fd) est obtenu par un revêtement durcissant à la cuisson.
